# EUROPEAN PATENT APPLICATION

(11) **EP 2 573 597 A1**
(43) Date of publication of application: **27.03.2013**
(21) Application number: 11783375.6
(22) Date of filing: 25.04.2011
(51) Int. Cl.: G02B 5/08, C03C 17/36, C03C 17/40, C23C 14/06

(54) **REFLECTION MEMBER**

(30) Priority: 19.05.2010 JP 2010115445
(71) Applicant: Nippon Electric Glass Co., Ltd., Otsu-shi Shiga 520-8639 (JP)
(72) Inventor: SAKURAI, Takeshi, Otsu-shi Shiga 520-8639 (JP)
(74) Representative: TER MEER - STEINMEISTER & PARTNER GbR
(86) International application number: PCT/JP2011/060033
(87) International publication number: WO 2011/145438

(57) **Abstract**

Provided is a reflection member including a silver reflective coating and having excellent thermal resistance. A reflection member (1) includes a reflection member body (11), a silver reflective coating (13), and a first protective film (15). The silver reflective coating (13) is formed on the reflection member body (11). The silver reflective coating (13) is made of silver or a silver-containing alloy. The first protective film (15) is formed on the silver reflective coating (13). The first protective film (15) is made of Ti, Ta or Nb.

## Description

### Technical Field

This invention relates to reflection members and particularly relates to a reflection member having a silver reflective coating.

### Background Art

Reflection members having silver reflective coatings made of silver or a silver-containing alloy are conventionally used. Silver reflective coatings have high light reflectance as compared to, for example, a reflective coating made of aluminum. Therefore, the use of a silver reflective coating can achieve a reflection member having a high light reflectance.

However, silver reflective coatings have a problem in that they have poor weatherability and, particularly, poor thermal resistance at high temperatures, thereby reducing their light reflectance with time. In view of such a problem, the following Patent Literatures 1 to 3, for example, describe that a protective film is formed on a silver reflective coating. Examples of protective films described in Patent Literatures 1 to 3 are a SiO₂ film, a Ni-Cr film, an Al₂O₃ film, and a TiO₂ film.

### Citation List

### Patent Literature

Patent Literature 1: JP 2876325
Patent Literature 2: JP-B H07-3483
Patent Literature 3: JP-A H08-234004

### Summary of Invention

### Technical Problem

However, even if a protective film is provided on a silver reflective coating, a reflection member having sufficiently excellent thermal resistance may not be obtained.

The present invention has been made in view of these points and an object thereof is to provide a reflection member including a silver reflective coating and having excellent thermal resistance.

### Solution to Problem

A reflection member according to the present invention includes a reflection member body, a silver reflective coating, and a first protective film. The silver reflective coating is formed on the reflection member body. The silver reflective coating is made of silver or a silver-containing alloy. The first protective film is formed on the silver reflective coating. The first protective film is made of Ti, Ta or Nb.

In the present invention, the first protective film made of Ti, Ta or Nb is formed on the silver reflective coating. Therefore, even when the reflection member is placed in a high-temperature atmosphere, the silver reflective coating can be suitably cut off from oxygen and sulfur in the air by the first protective film. Thus, the silver reflective coating can be effectively prevented from reacting with oxygen or sulfur in the air and thereby reducing the light reflectance thereof. Hence, by forming a first protective film made of Ti, Ta or Nb on the silver reflective coating in accordance with the present invention, a reflection member having excellent thermal resistance can be obtained. From the viewpoint of achieving particularly excellent thermal resistance, the first protective film is preferably made of Ti.

Specific examples of the silver-containing alloy include a Ag-Pd alloy and a Ag-Pd-Cu alloy, for example. The silver content in the silver-containing alloy is preferably 90% by mass or more.

In the present invention, the reflection member preferably further includes a second protective film formed between the silver reflective coating and the first protective film and the second protective film is made of an oxide. The provision of a second protective film made of an oxide effectively prevents the occurrence of migration of silver or the like between the silver reflective coating and the first protective film and the attendant reduction in the light reflectance of the silver reflective coating. Therefore, more excellent thermal resistance can be achieved.

In the present invention, no particular limitation is placed on the material of the second protective film so long as it is an oxide, but the second protective film is preferably made of titanium oxide, niobium oxide, zirconium oxide or tantalum oxide. The reason for this is that in such a case the thermal resistance of the second protective film itself can be increased and the adhesion of the second protective film to the silver reflective coating and the first protective film can be increased.

The second protective film preferably contains no Ag component, such as metal Ag or silver oxide. The reason for this is that if the second protective film contains an Ag component, migration may easily occur between the second protective film and each of the silver reflective coating and the first protective film.

In the present invention, no particular limitation is placed on the material of the reflection member body, but it is preferably a material having excellent thermal resistance. Specifically, the reflection member body is preferably made of glass, for example, and more preferably made of silicate glass or silicate crystallized glass.

In this case, however, if the silver reflective coating is formed directly on the reflection member body, the adhesion of the silver reflective coating may be likely to be low. Therefore, an underlying film is preferably formed between the reflection member body and the silver reflective coating. No particular limitation is placed on the material of the underlying film so long as it has excellent adhesion to the reflection member body and the silver reflective coating. The underlying film is preferably made of, for example, titanium oxide, aluminum oxide or zirconium oxide.

In the present invention, the reflection member preferably further includes a third protective film formed on a surface of the first protective film opposite to the second protective film. The first protective film made of Ti, Ta or Nb generally has lower mechanical durability than a protective film made of an oxide. Therefore, the provision of the third protective film can effectively prevent the first protective film from being damaged. As a result, higher thermal resistance can be achieved.

The third protective film preferably has a higher hardness than the first protective film. Specifically, the third protective film is preferably made of an oxide or a nitride. More specifically, the third protective film is preferably made of, for example, titanium oxide, niobium oxide, tantalum oxide, zirconium oxide, silicon oxide or silicon nitride. Advantageous Effects of Invention

The present invention can provide a reflection member including a silver reflective coating and having excellent thermal resistance.

### Brief Description of Drawings

[Fig. 1] Fig. 1 is a schematic cross-sectional view of a reflection member according to an embodiment in which the present invention has been implemented.
[Fig. 2] Fig. 2 is a schematic cross-sectional view of a reflection member according to a modification.
[Fig. 3] Fig. 3 is a graph representing the relation between heating temperature and average light reflectance in Example 1 and Comparative Examples 1 and 2.

### Description of Embodiments

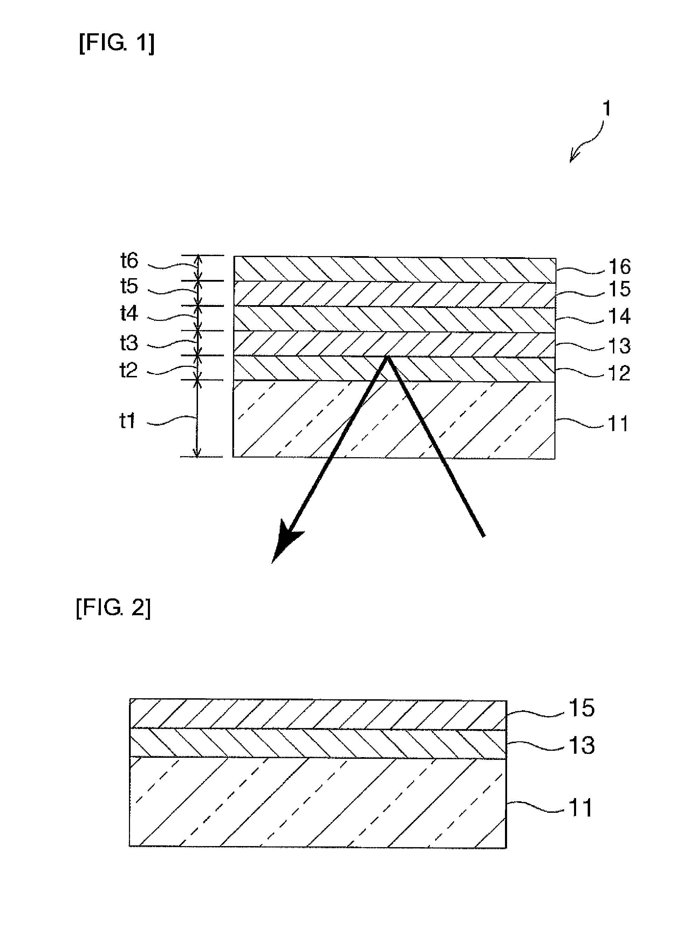

Hereinafter, a preferred embodiment in which the present invention has been implemented will be described by taking as an example a reflection member 1 shown in Fig. 1. However, the reflection member 1 is simply illustrative. The reflection member according to the present invention is not limited at all to the reflection member 1.

Fig. 1 is a schematic cross-sectional view of the reflection member 1 according to this embodiment.

The reflection member 1 according to this embodiment is a member for receiving light through a reflection member body 11 thereof and reflecting at a silver reflective coating 13 thereof.

The reflection member 1 includes the reflection member body 11. The reflection member body 11 transmits light to be reflected by the reflection member 1, such as sunlight. The reflection member body 11 is a member for ensuring the mechanical strength of the reflection member 1. No particular limitation is placed on the material of the reflection member body 11 so long as it can ensure the mechanical strength of the reflection member 1. The reflection member body 11 can be made of, for example, glass, ceramics or resin. Preferred among them is glass, such as silicate glass or silicate crystallized glass, or silicate ceramics because the reflection member body 11 should preferably have a low coefficient of thermal expansion and excellent thermal resistance. The coefficient of thermal expansion of the reflection member body 11 at 30°C to 380°C is preferably within the range from -5×10⁻⁷ /K to 90×10⁻⁷/X.

No particular limitation is placed on the thickness t1 of the reflection member body 11 so long as it can ensure the mechanical strength of the reflection member 1. The thickness t1 of the reflection member body 11 can be, for example, about 0.1 mm to about 10 mm.

The silver reflective coating 13 is formed on the reflection member body 11. The silver reflective coating 13 is a film for primarily assuming the reflection characteristic of the reflection member 1. The silver reflective coating 13 is made of silver or a silver-containing alloy. In the silver-containing alloy, the silver content is preferably 90% by mass or more. Specific examples of the silver-containing alloy include a Ag-Pd alloy and a Ag-Pd-Cu alloy, for example.

The thickness t3 of the silver reflective coating 13 is preferably not less than 100 nm, for example, and more preferably not less than 150 nm. The reason for this is that if the thickness t3 of the silver reflective coating 13 is too small, the light reflectance of the silver reflective coating 13 may become too low. However, if the thickness t3 of the silver reflective coating 13 is too large, the cost for the formation of the silver reflective coating 13 becomes high. Therefore, the thickness t3 of the silver reflective coating 13 is preferably not more than 500 nm and more preferably not more than 300 nm.

An underlying film 12 is provided between the silver reflective coating 13 and the reflection member body 11. This underlying film 12 has the function of increasing the adhesion strength between the silver reflective coating 13 and the reflection member body 11. Therefore, the underlying film 12 is formed of such a material that each of the adhesion strength between the underlying film 12 and the silver reflective coating 13 and the adhesion strength between the reflection member body 11 and the silver reflective coating 13 is higher than that between the silver reflective coating and the reflection member body when the silver reflective coating is formed directly on the reflection member body. The material for the underlying film 12 can be appropriately selected depending upon the types and the like of the reflection member body 11 and the silver reflective coating 13. The underlying film 12 is preferably made of, for example, titanium oxide, aluminum oxide or zirconium oxide.

No particular limitation is placed on the thickness t2 of the underlying film 12 so long as it can increase the adhesion strength between the silver reflective coating 13 and the reflection member body 11. The underlying film 12 can be, for example, 10 nm to 500 nm, both inclusive.

A first protective film 15 is formed on the silver reflective coating 13. The first protective film 15 is made of Ti, Ta or Nb. Therefore, the first protective film 15 has low permeability to oxygen and sulfur in the air. Thus, the formation of the first protective film 15 on the silver reflective coating 13 enables suitable protection of the silver reflective coating 13 from oxygen and sulfur in the air, so that the reflective coating 13 can be effectively prevented from reacting with oxygen or sulfur in the air and thereby reducing the light reflectance thereof. Accordingly, excellent thermal resistance can be achieved. From the viewpoint of achieving particularly excellent thermal resistance, the first protective film 15 is more preferably made of Ti.

The thickness t5 of the first protective film 15 is preferably 30 nm to 1000 nm, more preferably 50 nm to 500 nm, and still more preferably 100 nm to 400 nm. If the thickness t5 of the first protective film 15 is too small, the above effect of cutoff from oxygen and sulfur may not sufficiently be achieved. If the thickness t5 of the first protective film 15 is too large, the light reflectance of the reflection member 1 may become too low or the first protective film 15 may be easily peeled off.

Because of silver being likely to migrate, if, for example, the first protective film made of Ti, Ta or Nb is formed directly on the silver reflective coating, migration may occur between the first protective film made of metal and the silver reflective coating so that the light reflectance of the silver reflective coating may be reduced.

Unlike the above, in this embodiment, a second protective film 14 made of an oxide is formed between the silver reflective coating 13 and the first protective film 15 made of metal. Therefore, Ag migration from the silver reflective coating 13 can be effectively prevented. As a result, the reduction in light reflectance of the reflection member 1 can be prevented.

The second protective film 14 is preferably a film that can prevent Ag migration and has high strength of adhesion to the silver reflective coating 13 and the first protective film 15 and excellent thermal resistance. Therefore, the second protective film 14 is preferably made of, for example, titanium oxide, niobium oxide, zirconium oxide or tantalum oxide. In addition, the second protective film 14 preferably contains no Ag component, such as metal Ag or silver oxide.

No particular limitation is placed on the thickness t4 of the second protective film 14 so long as it can prevent Ag migration. The thickness t4 of the second protective film 14 is preferably about 10 nm to about 100 nm, for example. If the thickness t4 of the second protective film 14 is too small, Ag migration may not be able to be sufficiently prevented. If the thickness t4 of the second protective film 14 is too large, the second protective film 14 may be easily peeled off.

In this embodiment, a third protective film 16 is formed on the first protective film 15. By this third protective film 16, the first protective film 15 made of Ti, Ta or Nb and having a low hardness is suitably protected. Therefore, higher thermal resistance can be achieved.

Although no particular limitation is placed on the material of the third protective film 16, it is preferably a film having a higher hardness than the first protective film 15. Therefore, the third protective film 16 is preferably made of, for example, titanium oxide, niobium oxide, tantalum oxide, zirconium oxide, silicon oxide or silicon nitride.

No particular limitation is placed on the thickness t6 of the third protective film 16 so long as it can suitably protect the first protective film 15; for example, the thickness thereof can be about 100 nm to about 1000 nm.

In this embodiment, no particular limitation is placed on the respective methods for forming the underlying film 12, the silver reflective coating 13, and the first to third protective films 14 to 16. Each of the underlying film 12, the silver reflective coating 13, and the first to third protective films 14 to 16 can be formed by, for example, a thin film deposition process, such as vapor deposition, sputtering or CVD (chemical vapor deposition). Furthermore, the first protective film 15 made of Ti, Ta or Nb is preferably formed in an inert gas atmosphere or a reducing atmosphere. Moreover, it is preferred that after the formation of the silver reflective coating 13, the silver reflective coating 13 should be subjected to a heat treatment, for example, at about 100°C to about 200°C. Thus, silver grain growth in the silver reflective coating 13 can be promoted. As a result, a higher light reflectance can be achieved.

### (Modification)

Fig. 2 is a schematic cross-sectional view of a reflection member according to a modification.

The above embodiment has described an example in which the underlying film 12 is formed between the silver reflective coating 13 and the reflection member body 11 and the second and third protective films 14, 16 are formed on both sides of the first protective film 15. In the present invention, however, the underlying film 12 and the second and third protective films 14, 16 are not necessarily essential. At least one of the underlying film 12 and the second and third protective films 14, 16 may not be formed. Alternatively, for example, a reflection member may be composed of a reflection member body 11, a silver reflective coating 13, and a first protective film 15 with none of an underlying film 12 and second and third protective films 14, 16 formed, as shown in Fig. 2.

The present invention will be described below in further detail with reference to specific examples, but the present invention is not limited at all to the following examples and can be implemented by appropriately changing it without departing from the gist of the invention.

### (Example 1)

In Example 1, a reflection member having the same structure as the reflection member according to the above embodiment shown in Fig. 1, except that the second and third protective films 14, 16 were not formed, was made in the following manner. Specifically, an Al₂O₃ film of 20 nm thickness was formed on a glass substrate by sputtering. Next, a silver reflective coating of 150 nm thickness was formed on the Al₂O₃ film by sputtering. Finally, a Ti film of 150 nm thickness was formed on the silver reflective coating by sputtering to make a reflection member according to Example 1.

### (Example 2)

A reflection member according to Example 2 was made in the same manner as in Example 1 except that instead of the Ti film a Nb film of 150 nm thickness was formed.

### (Comparative Example 1)

A reflection member according to Comparative Example 1 was made in the same manner as in Example 1 except that the Ti film was not formed.

### (Comparative Example 2)

A reflection member according to Comparative Example 2 was made in the same manner as in Example 1 except that instead of the Ti film an Al film of 150 nm thickness was formed.

### (Comparative Example 3)

A reflection member according to Comparative Example 3 was made in the same manner as in Example 1 except that instead of the Ti film a laminate of a Cu film of 150 nm thickness and an Al film of 150 nm thickness was formed.

### (Comparative Example 4)

A reflection member according to Comparative Example 4 was made in the same manner as in Example 1 except that instead of the Ti film a Si film of 100 nm thickness was formed.

### (Comparative Example 5)

A reflection member according to Comparative Example 5 was made in the same manner as in Example 1 except that instead of the Ti film a laminate of a Si film of 10 nm thickness and a SiN film of 100 nm thickness was formed.

### (Comparative Example 6)

A reflection member according to Comparative Example 6 was made in the same manner as in Example 1 except that instead of the Ti film a laminate of a Si film of 100 nm thickness and a Ti film of 150 nm thickness was formed.

### (Comparative Example 7)

A reflection member according to Comparative Example 7 was made in the same manner as in Example 1 except that instead of the Ti film a SiN film of 100 nm thickness was formed.

### (Comparative Example 8)

A reflection member according to Comparative Example 8 was made in the same manner as in Example 1 except that instead of the Ti film a TiN film of 150 nm thickness was formed.

### (Heat Test 1)

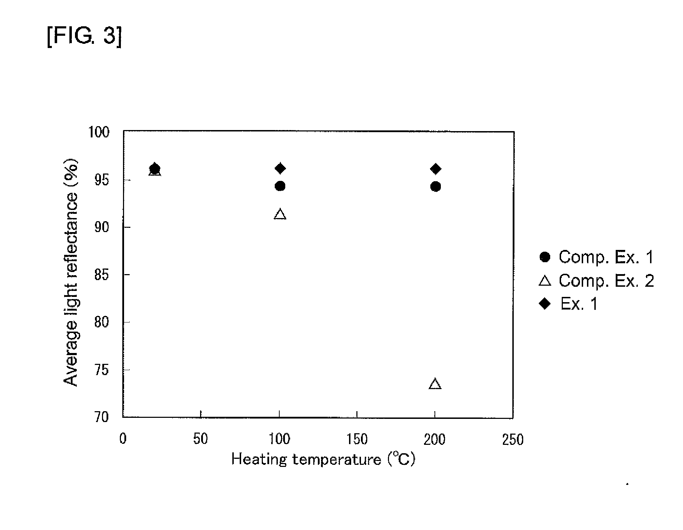

The reflection members of each type made in each of Example 1 and Comparative Examples 1 and 2 were allowed to stand for 120 hours in thermostat baths at 25°C, 100°C, and 200°C, all at a humidity of 85%. Thereafter, the average light reflectance of the reflection members of each type when light of 400 nm to 2500 nm wavelength was incident on them at an incident angle of 12° was measured using U-4000 manufactured by Hitachi, Ltd. The results are shown in Fig. 3.

As shown in Fig. 3, the reflection members of Example 1 and Comparative Examples 1 and 2 exhibited approximately equal light reflectances at 25°C. However, as the heating temperature increased, Comparative Example 1 in which no protective film was formed and Comparative Example 2 in which an Al film was formed as a protective film had tendency to decrease the light reflectance. This can be attributed to the fact that in Comparative Example 1 in which no protective film was formed and Comparative Example 2 in which an Al film was formed as a protective film, their silver reflective coatings were degraded. Particularly, the reason why the light reflectance was significantly decreased in Comparative Example 2 in which an Al film was formed as a protective film can be that Al and Ag migration occurred between the Al film and the silver reflective coating to decrease the light reflectance of the silver reflective coating.

Unlike the above, in Example 1 in which a Ti film was formed as a first protective film, the light reflectance was slightly decreased even when it was heated to 200°C. These results show that the formation of a Ti film as a first protective film provides excellent thermal resistance.

### (Heat Test 2)

The reflection members of each type made in each of Examples 1 and 2 and Comparative Examples 2 to 8 were allowed to stand for 120 hours in thermostat bathes at 100°C, 200°C, and 300°C. Thereafter, the average light reflectance of the reflection members of each type when light of 400 nm to 2500 nm wavelength was incident on them at an incident angle of 12° was measured using U-4000 manufactured by Hitachi, Ltd. The reflection members were evaluated in a manner that "circle" indicates when the average light reflectance after the conduction of the heat test was 93% or more and "cross" indicates when the average light reflectance after the conduction of the heat test was less than 93% or peeling occurred between the silver reflective coating and the protective film. The results are shown in Table 1 below.

### (Peel Test)

In the reflection member made in each of Examples 1 and 2 and Comparative Examples 2 to 8, five cuts were made at 5 mm intervals with a cutter knife to pass through the underlying film, the silver reflective coating, and the protective film. A piece of Scotch tape #610 manufactured by 3M was applied to the reflection member across the five cuts and then the operation of pulling away the Scotch tape was repeated five times. Thus, the reflection members were evaluated in a manner that "cross" indicates when peeling occurred between the silver reflective coating and the protective film and "circle" indicates when no peeling occurred. The results are shown in Table 1 below.

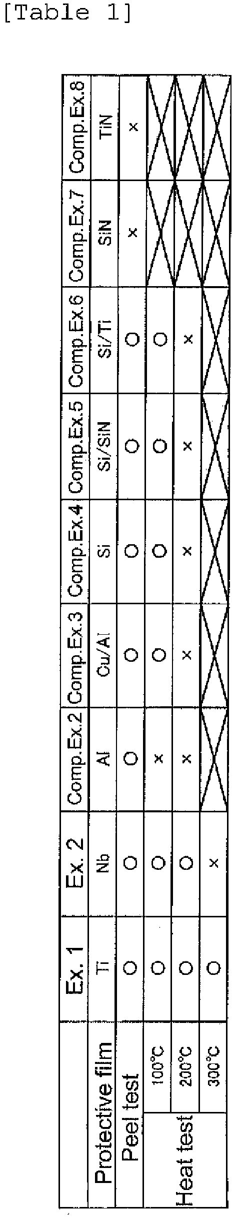

As shown in Table 1 above, in Comparative Examples 2 and 3 in which an Al film or a Cu/Al film was provided as a protective film, the average light reflectance in the 200°C heat test was less than 93%. In Comparative Examples 4 to 6 in which an Si film, an Si/SiN film or an Si/Ti film was provided as a protective film, peeling occurred between the silver reflective coating and the Si film after the conduction of the 200°C heat test. In Comparative Examples 7 and 8 in which an SiN film or a TiN film was provided as a protective film, peeling occurred between the silver reflective coating and the protective film in the peel test. These results show that if an SiN film or a TiN film is provided as a protective film, the mechanical durability of the reflection member will be deteriorated.

Unlike the above, in Examples 1 and 2 in which a Ti film or a Nb film was provided as a protective film, no peeling occurred in the peel test and the average light reflectance was 93% or more even after the 200°C heat test. Particularly in Example 1 in which a Ti film was provided as a protective film, the average light reflectance was maintained at 93% or more even after the 300°C heat test. These results show that the provision of a Ti film or a Nb film as a protective film achieves high mechanical durability and high thermal resistance and the provision of a Ti film as a protective film achieves particularly high thermal resistance.

### Reference Signs List

1...reflection member
11...reflection member body
12...underlying film
13...silver reflective coating
14...second protective film
15...first protective film
16...third protective film

## Claims

1. A reflection member comprising:
a reflection member body;
a silver reflective coating formed on the reflection member body and made of silver or a silver-containing alloy; and
a first protective film formed on the silver reflective coating and made of Ti, Ta or Nb.

2. The reflection member according to claim 1, wherein the first protective film is made of Ti.

3. The reflection member according to claim 1 or 2, further comprising a second protective film formed between the silver reflective coating and the first protective film and made of an oxide.

4. The reflection member according to claim 3, wherein the second protective film is made of titanium oxide, niobium oxide, zirconium oxide or tantalum oxide.

5. The reflection member according to claim 3 or 4, wherein the second protective film contains no Ag component.

6. The reflection member according to any one of claims 1 to 5, wherein
the reflection member body is made of glass, and
the reflection member further comprises an underlying film formed between the reflection member body and the silver reflective coating.

7. The reflection member according to claim 6, wherein the underlying film is made of titanium oxide, aluminum oxide or zirconium oxide.

8. The reflection member according to any one of claims 1 to 7, further comprising a third protective film formed on a surface of the first protective film opposite to the second protective film.

9. The reflection member according to claim 8, wherein the third protective film is made of titanium oxide, niobium oxide, tantalum oxide, zirconium oxide, silicon oxide or silicon nitride.
